# EUROPEAN PATENT SPECIFICATION

(11) **EP 3 794 913 B1**
(45) Date of publication and mention of the grant of the patent: **01.05.2024**
(21) Application number: 18727727.2
(22) Date of filing: 17.05.2018
(51) Int. Cl.: H05K 7/14

(54) **SHIELDING OF HIGH VOLTAGE EQUIPMENT**
ABSCHIRMUNG EINES HOCHSPANNUNGSGERÄTS
BLINDAGE D'ÉQUIPEMENT À HAUTE TENSION

(43) Date of publication of application: 24.03.2021
(73) Proprietor: Hitachi Energy Ltd, 8050 Zürich (CH)
(72) Inventor: DIAZ, Oscar, 77143 Ludvika (SE); WU, Dong, 183 47 Täby (SE); BURMAN, Michael, 77142 Ludvika (SE)
(74) Representative: AWA Sweden AB
(86) International application number: PCT/EP2018/062878
(87) International publication number: WO 2019/219194

(56) References cited:
- WO-A1-2007/149023
- WO-A1-2011/009482
- WO-A1-2013/075754
- CN-B- 101 917 836
- CN-U- 206 042 672

## Description

### FIELD OF INVENTION

The present invention relates to a shielding electrode for a piece of high voltage equipment, a shielding structure for a piece of high voltage equipment comprising such a shielding electrode, a high voltage arrangement comprising a piece of high voltage equipment and such a shielding structure as well as a converter station comprising a converter and such a shielding structure.

### BACKGROUND

The increasing demand of reliable and continuous electrical energy supply has been pushing the limits on the maximum operative voltage levels in Alternating Current (AC) and High Voltage Direct Current (HVDC) power transmission systems.

This has consequences on the electrical shielding made on equipment in these systems.

In high voltage (HV) stations, bus terminals and interconnections, it is a common practice to use large radius metallic shields to soften the electric field. These shields should be free of corona electrical discharges and withstand a given voltage level according with the equipment location and its specific insulation requirements.

The air insulation design of HV equipment must consider the switching impulse withstand level (SIWL), the creepage distance among other additional parameters.

Corona electrical discharges are partial discharges that initiate at high electric field concentrations on the surface of any electrode. Additional parameters that influence the corona inception voltage are the electrode geometry and the surrounding air density and humidity. Once a corona discharge has been incepted, streamer discharges will follow. Then, depending upon the local electric field conditions in the electrode vicinity, the transition to leader discharge and finally the full discharge will bridge the air gap.

As is mentioned above, the use of large radius shield electrodes is a common practice in HV stations for equipment like power reactors, capacitor banks, disconnectors, surge arresters, interconnection of bus bars, transformers, wall bushings and insulator terminals. The same principle applies when the internal elements in a piece of equipment, like HVDC converter valves, must be shielded towards the outside, avoiding undesired concentrations of electric fields that might lead to air insulation failures.

In the art different ways of shielding may be provided. However, it is important to obtain sufficient shielding combined with a compact shield size, especially when the voltages are high.

WO 2007/149023 discloses a converter valve for converting between alternating voltage and direct voltage comprising a converter valve stack. Shielding is here obtained through using shielding plates on front and back sides and metallic cooling medium tubes on short sides of the stack.

WO 2011/009482 discloses an electrical field shielding assembly for placement about electrical equipment, which assembly comprises at least one primary electrically conductive shielding element connected to at least one secondary electrically conductive shielding element. The or each primary shielding element presents a continuous and uninterrupted outer shielding surface for being placed at a corner of the equipment. The or each secondary shielding element presents a broken outer shielding surface. As a single solid shielding element is provided at the corner of the piece of equipment that is to be shielded, the shield becomes bulky.

It is in view of what has been mentioned above of interest to obtain an improved shielding electrode and shielding structure for a piece of high voltage equipment, and especially a compact shielding electrode and structure that fulfills SIWL requirements.

CN101917836A discloses, according to a machine translation thereof, a shielding device applied to a high voltage direct current converter valve. According to the machine translation of CN101917836A, it discloses that the shielding device comprises a module shielding plate, a top shielding cover and a bottom shielding cover, and that the module shielding plate comprises angle shielding plates and short shielding plates which are positioned on different valve layers of the converter valve and arranged at the periphery of a valve module and encircle the three surfaces of the valve module of the converter valve, and further that two angle shielding plates are arranged at the periphery of the valve module along the two ends of the width direction respectively, and that three short shielding plates are arranged at the periphery of the valve module along the length direction of the valve module in turn.

CN206042672U discloses, according to a machine translation thereof, a layer shielding device applied to an ultra-high voltage direct current transmission converter valve, comprising corner shields and side shields located on different valve layers of the converter valve and arranged around the periphery of the valve assembly, wherein four corner shields are located on the periphery of the valve layer.

### SUMMARY OF THE INVENTION

One object of the present invention is therefore to obtain shielding for a piece of high voltage equipment that is compact in size while fulfilling the switching impulse withstand level requirement.

This object is according to a first aspect achieved through a shielding electrode for a piece of high voltage equipment having a first and second end, a first and second side and an edge separating the first side from the second side, where the edge stretches along a direction between the first end and the second end. The shielding electrode comprises two tubular shielding elements, each comprising a first and second straight tubular section, joined to each other by a bent central tubular section and stretching out from the central bent section, at an angle of at least sixty degrees to each other, where the central section is configured to be centered around the edge with the first and second straight sections stretching along the two sides and the two shielding elements are configured to be placed after each other along the direction. Each straight section of each tubular element of the shielding electrode is further joined with a hemispherical dome opposite of the joining to the central section.

The object is according to a second aspect achieved through a shielding structure for a piece of high voltage equipment, where the piece of high voltage equipment has a first and second end, a first and second side and an edge separating the first side from the second side, where the edge stretches along a direction between the first end and second end and the piece of equipment has an electric potential that varies along the edge. The shielding structure comprises a shielding electrode according to the first aspect.

The object is according to a third aspect achieved through a high voltage arrangement comprising a piece of high voltage equipment having a first and second end, a first and second side and an edge separating the first side from the second side, where the edge stretches along a direction between the first end and the second end and the equipment has a varying electric potential along the edge. The high voltage arrangement further comprises a shielding structure according to the second aspect.

The object is according to a fourth aspect achieved through a converter station comprising a converter for converting between alternating current and direct current, which converter comprises a valve stack having a first and second end, a first and second side and an edge separating the first side from the second side, where the edge stretches along a direction between the first end and the second end and the converter has a varying electric potential along the edge. The converter station furthermore comprises a shielding structure according to the second aspect.

The tubular shielding elements of the shielding electrode may also be electrically interconnected with each other. Additionally, the shielding electrode may or may not be electrically connected to a part of the piece of equipment from the valve stack having an electric potential.

The above-mentioned angle between the first and the second sides may additionally be at least ninety degrees. The angle between the first and second tubular shielding elements may also depend on an angle between the first and second sides of the piece of high-voltage equipment. The angles may for instance be the same.

The straight sections of a shielding element may be angled to each other in a second way. One straight section may be essentially horizontally oriented, while the other straight section may lean with an angle to the horizontal plane. There may therefore be a difference in an angle of inclination between the straight sections in relation to the horizontal plane. One straight section may lack such an angle of inclination, while the other straight section may have such an angle of inclination.

The straight tubular section covering the first side may stretch out along the first side perpendicular to the above-mentioned direction.

The electric potential at the first end of the piece of high-voltage equipment may be higher than the electric potential at the second. The electric potential at the first end may in fact be the highest of the equipment, where it is further possible that the electric potential is higher than 400 kV. The potential may as an example be up to 1100 or around 1100 kV. In all these cases the shielding electrode may be configured to be placed closer to the first end than it is to the second end.

The piece of high voltage equipment may comprise a third side and a further edge separating the second side from the third side, which further edge also stretches along a further direction between the first end and second end, where the piece of equipment has an electric potential that varies along the further edge, the further direction of which may the same as the direction of the first mentioned edge.

In this case the shielding structure may additionally comprise a further shielding electrode comprising two tubular shielding elements, each comprising a first and second straight tubular section, joined to each other by a bent central tubular section and stretching out from the central bent section, at an angle of at least sixty degrees to each other, where the central section is configured to be centered around the further edge with the first and second straight sections stretching along second and third sides and the two shielding elements are configured to be placed after each other along the further direction.

The shielding structure may also comprise a further shielding element for covering the first end of the piece of high voltage equipment and the shielding electrode may be configured to be placed adjacent the further shielding element. The shielding electrode may thereby also be placed closer to the first than the second end. It is also possible that the distance between the shielding electrode and the second end is at least five times bigger than the distance between the shielding electrode and the first end. The further shielding element may be bowl shaped.

It is also possible that there are cooling fluid tubes on the second side of the piece of high voltage equipment. In this case the tubular shielding elements may cover at least some of the cooling fluid tubes in the vicinity of the first edge. These tubes may comprise tubes at the bottom of the stack at the first edge between the first and the second sides, where it is additionally possible that parts of these tubes that are closer to the first edge than the second edge are covered.

At least some of the cooling fluid tubes may be made of an electrically conducting material for shielding the second side of the piece of equipment.

In this case the straight tubular section of a shielding electrode covering the second side may stretch out along the second side with an orientation that is aligned with the orientation of the cooling fluid tubes on the second side.

The shielding structure may further comprise shielding plates, perhaps with rounded edges, for placement on the first side of the piece of high-voltage equipment.

The high voltage equipment may be a converter comprising a number of converter valves stacked along the previously mentioned direction. As an alternative it may be a high voltage power reactor.

The present invention provides a new type of corona shield for high voltage equipment, to ensure the external shielding of large devices from its corners/edges towards the surrounding grounded planes/bodies.

The invention has a number of advantages. It provides compact shielding electrode that fulfils the SIWL requirements. It may also be simple to produce in an economic manner.

### BRIEF DESCRIPTION OF THE DRAWINGS

The present invention will in the following be described with reference being made to the accompanying drawings, where
fig. 1 schematically shows a front view of a grounded enclosure in the form of a valve hall comprising a piece of high-voltage equipment in the form of a converter valve stack provided with a shielding structure,
fig. 2 shows a shielding structure for the piece of equipment in the same front view,
fig. 3 shows a side view of the shielding structure,
fig. 4 illustrates a view from above of a shielding electrode used in the shielding structure,
fig. 5 illustrates a view of the shielding electrode seen from a side that is to be connected to the piece of equipment,
fig. 6 shows a side view of the shielding electrode, and
fig. 7 shows an isometric view of the shielding electrode.

### DETAILED DESCRIPTION OF THE INVENTION

The present invention concerns high voltage (HV) equipment for high power applications. The HV equipment may be a High Voltage Direct Current (HVDC) equipment operating at HV such as at 400 kV and above. It may with advantage be equipment operating at 800 kV and above, such as at 1100 kV and above. The equipment may furthermore be enclosed in an enclosure that has a different electric potential than the voltage at which the piece of equipment operates. It is for instance possible that the enclosure is grounded while the piece of equipment may operate at a voltage level of + 1100kV or -1100 kV or some high voltage there between. The equipment may for instance be a converter, converting between alternating Current (AC) and Direct Current (DC). The equipment may as an alternative be a power reactor, capacitor bank, disconnector, surge arrester, bus bar interconnection, transformer, wall bushing or an insulator terminal.

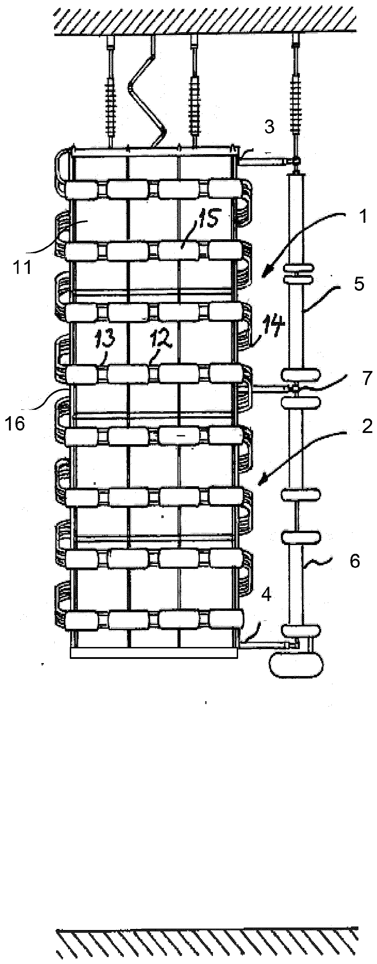

Fig. 1 schematically shows a front view of one such exemplifying HVDC converter. The converter is enclosed in an enclosure, which enclosure in this case is a building in the form of a valve hall comprising grounded walls, i.e. walls having an electric zero potential as well as grounded floors and ceiling. In fig. 1 the floor and celling are shown. The enclosure is one example of an object close to at least one piece of the HV equipment.

The converter comprises a number of valves. In the example given in fig. 1 the HVDC converter comprises two valves 1 and 2. As an example, the valves 1 and 2 may be installed hanging from the valve hall ceiling and fixed to the ceiling via suspending insulators. It should be realized that the way that the valves are being placed in the enclosure is not central and that they may as an exemplifying alternative be placed on a supporting structure on the valve floor.

The converter has power semiconductor devices connected in series in the converter valves or switches of cascaded submodules in the converter valve. The two valves 1 and 2 are arranged on top of each other in a column or stack having a substantially rectangular cross-section. A first end 4 of the column is adapted to be connected to a high potential, whereas a second end 3 is adapted to be connected to a low potential. Surge arresters 5, 6 are connected in parallel with the converter valves 1 and 2 for protecting the converter valve against over-voltages. An AC-system is intended to be connected to the midpoint 7 between the converter valves 1 and 2.

The converter has power semiconductor devices, such as thyristors or transistors, which as an example may be arranged in substantially horizontal rows extending along opposite sides, which may be along the front side shown in fig. 1 and the back side, which is hidden. The rows may be interconnected so that they form a serpentine path up from the first 4 to the second end 3.

In operation, the power semiconductor devices dissipate heat. Therefore, a cooling system is also provided.

This cooling system comprises cooling blocks 11 of for instance aluminum arranged in contact with each of the semiconductors. These blocks are cooled by cooling fluid, such as water, passing through the cooling blocks in tubes 12 extending in a loop around the converter.

The cooling fluid tubes 13 at the front and back sides of the column or stack may be made of an electrically insulating material, such as plastic, whereas the tubes 14 on the short sides between the front and back sides, where no connections to cooling blocks are made, may be made of an electrically conducting material, for instance metal, such as aluminum or stainless steel. There are thus cooling fluid tubes on the second side of the equipment.

The front side of the valve stack is here a first side, the left short side of the valve stack is a second side, the back side of the valve stack is a third side and the right fourth side of the valve stack, at which the surge arresters 5 and 6 are provided, is a fourth side, where the sides are separated from each other through edges, which may be formed as the edges of the cooling blocks on the first and third sides. There is thereby a first edge separating the first side from the second side, a second edge separating the second side from the third side, a third edge separating the third side from the fourth side and a fourth edge separating the fourth side from the first side.

As can be seen in fig. 1 the first edge 16 is provided between the first and second sides of the valve stack.

It can thereby be seen that the piece of HV equipment has the first and second ends 4 and 3, a first and second side and a first edge 16 separating the first side from the second side, where the first edge 16 stretches or extends along a direction between the first and second end 4 and 3. The two ends are thus at opposite sides of the first edge. The electric potential at the first end 4 is higher than the electric potential at the second end 3. Moreover, due to the fact that the electric potential at the first end is higher than the electric potential at the second end, it is clear that the piece of equipment has an electric potential that varies along the first edge 16. The electric potential at the first end 4 may in fact be the highest of the equipment, which may be higher than 400 kV and approaching 1100 kV.

There is also a shielding structure comprising a plurality of shields for providing shielding against corona discharges. The shields are provided for protecting exposed surfaces on the valves to avoid possible corona discharges or electrical breakdown between the enclosure and the valves. A shielding structure for shielding the stack from high electric field concentrations has to be arranged around the stack outside the layers of power semiconductor devices, and this is on the first and third sides achieved by arranging electric field shielding screens 15 in the form of plates with rounded edges of for instance aluminum. These are arranged on the outside of the plastic tubes 13. Shielding plates are thus placed on the first and third side of the piece of equipment.

The structure described so far already exists, and is for instance essentially described in WO 2007/ 149023.

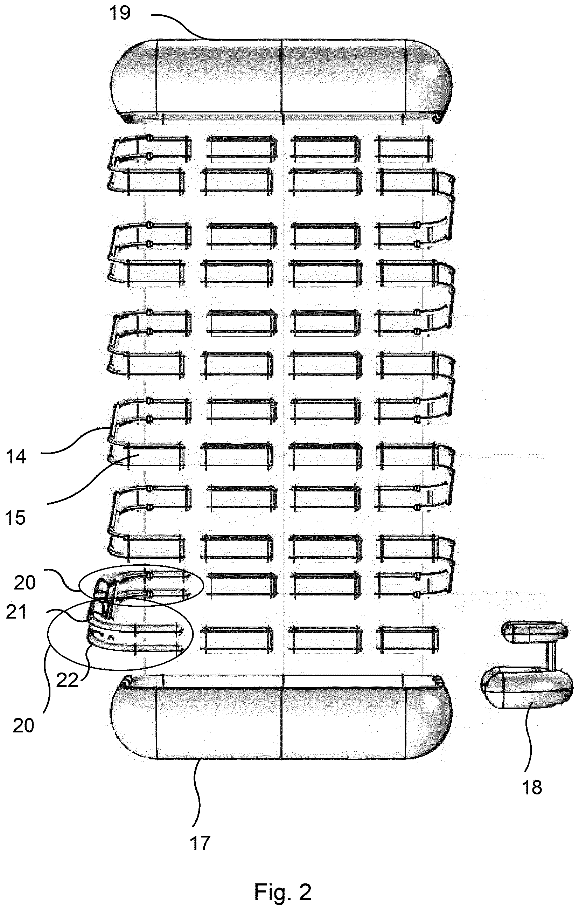

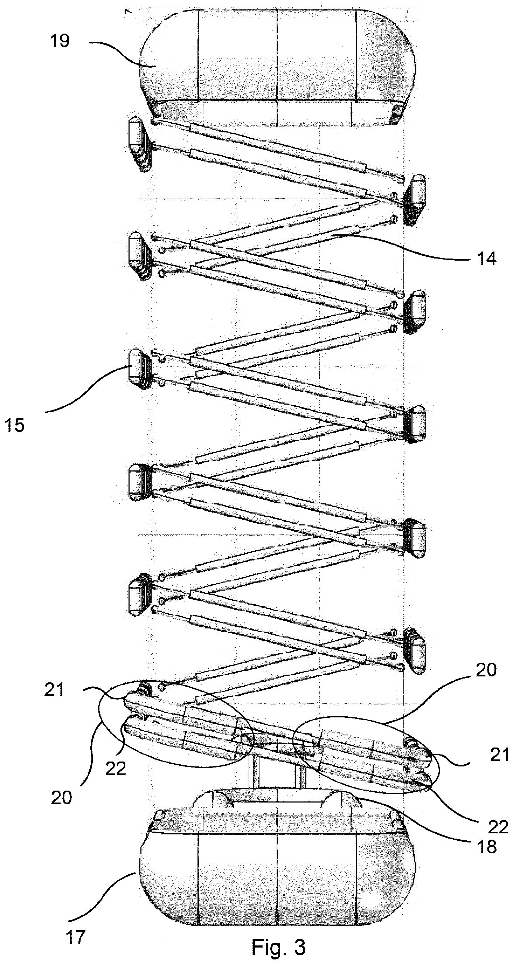

The shielding structure used is shown in more detail in fig. 2, which is a front view from the same side as fig. 1 and fig. 3, which is a side view of the shielding structure seen from the second side of the converter stack. As can be seen in the fig. 2 and 3, the cooling fluid tubes are a part of the shielding structure. However, it can also be seen that the shielding structure differs from the structure in WO 2007/ 149023 in a number of ways.

There is a first further shielding element 17 for covering the first end 4 of the valve stack, which further shielding element 17 is with advantage bowl shaped. There is also a second further shielding element 19 having the same shape and covering the second end 3 of the valve stack. As can be seen in the figures there is furthermore a third further shielding element 18 for surge arrester column and connecting bars of the first end of the valve stack.

As can be seen in fig. 2 and 3, there are also two HV shielding electrodes 20 in the shielding structure. Such a shielding electrode 20 comprises two tubular, essentially L-shaped, shielding elements 21 and 22 and the two shielding elements 21 and 22 are placed after each other along the direction and placed around the first edge 16 between the first and second sides of the valve stack as well as between the second edge between the second and third sides of the valve stack. It can be seen that each shielding electrode 20 is placed closer to the first 4 than the second end 3 and is placed adjacent the first further shielding element 17. Thereby it is possible that the distance between a shielding electrode and the second end is at least five times bigger than the distance between the electrode and the first end. It can also be seen that a first of the electrodes 20 may replace a plate 15 on the first side. However, it can also be seen that covers more than the plate it replaces. It also covers at least a part of the second side. It can more particularly be seen that the tubular shielding elements 21 and 22 of the electrodes 20 cover at least some of the cooling fluid tubes 14 in the vicinity of the edge 16 between the first and second sides. As can also be seen a second of the electrodes replaces a plate on the third side of the valve stack, where this second electrode covers at least a part of the second side and at least some of the cooling fluid tubes 14 in the vicinity of the edge between the second and third sides.

It may here be mentioned that it is possible that there is only one shielding electrode at one edge, for instance the first edge. It is also possible that as compared with the realization in fig. 2 and 3, also the two remaining edges of the valve stack are provided with shielding electrodes.

Generally, with regard to shielding, clearances between different equipment and walls at HV stations are based on the SIWL. This requirement for the insulation means that it should withstand a fast, strong voltage transient without having incepted corona electrical discharges. Departing from the equipment type, rated voltage and geometry dimensions, there are possible solutions for the external shielding of a piece of HV equipment.

The main factors that may be considered while designing shields for HV equipment would be: a) they are meant to be free of corona discharges; b) they should meet all the mechanical constraints given by each specific situation, like dimensions, weight, etc.; and c) they should be possible to manufacture, considering materials, processes, cost, etc.

Generally, the shields used on HVDC converter valves consist of large metallic bodies with rounded edges with lengths up to a few meters. The further shielding element 17 is a good example of this. These shields are located on the outer part of the equipment, fixed directly to the main structure. At certain spots on the equipment, the electric field concentrations arise, being necessary to use of a shielding electrode, which must comply with the electric field stresses caused by the required SIWL all over its surfaces.

As can be seen the use of metal tubes 14 on the short sides of the column for the cooling fluid, allows these tubes to be used as screens, where a number of such tubes may be considered to form a shielding electrode. Thereby the tubes have a dual use. Traditionally it has been sufficient to use such cooling fluid tubes as Corona shields. However, due to the increasing voltage levels, these may not be enough, especially at the end of the valve stack that may experience the highest potential. Therefore, the shielding electrode 20 has been introduced.

It can be seen from fig. 2 and 3 that for the converter stack in fig. 1, the tubes at the bottom of the stack at the first edge 16 between the first and the second sides and at the second edge between the second and third sides, i.e. closest to the first end 4, are covered by the shielding electrodes 20 comprising the two tubular shielding elements 21 and 22. It is here possible that parts of these tubes along the second side that are closer to the first edge than the second edge and parts of the tubes along the first side that are closer to the first edge than the fourth edge are covered by one of the electrodes and that parts of the tubes along the second side that are closer to the second edge than the first edge and parts of the tubes along the third side that are closer to the second edge than the third edge are covered by another electrode.

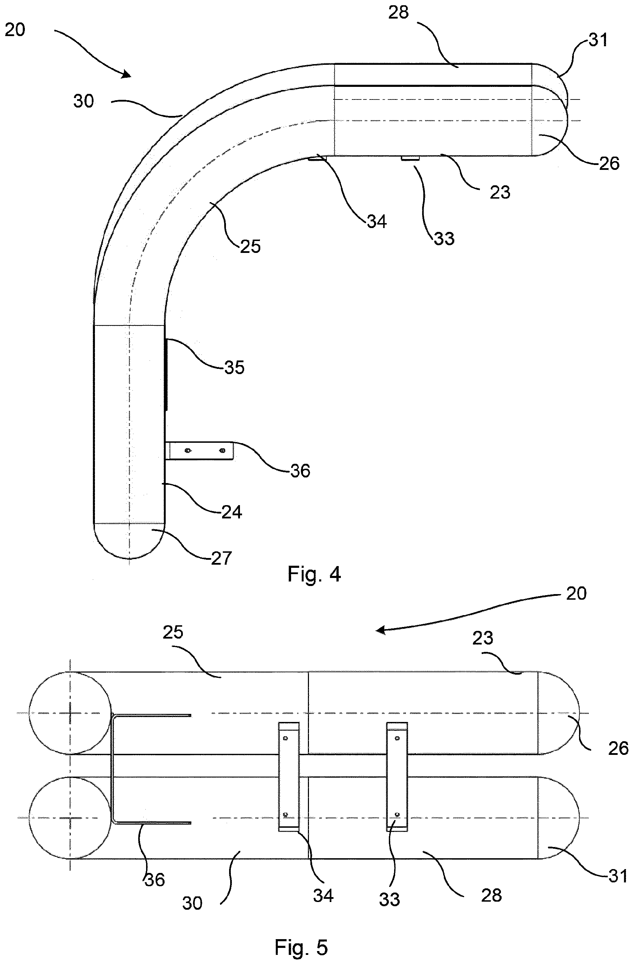

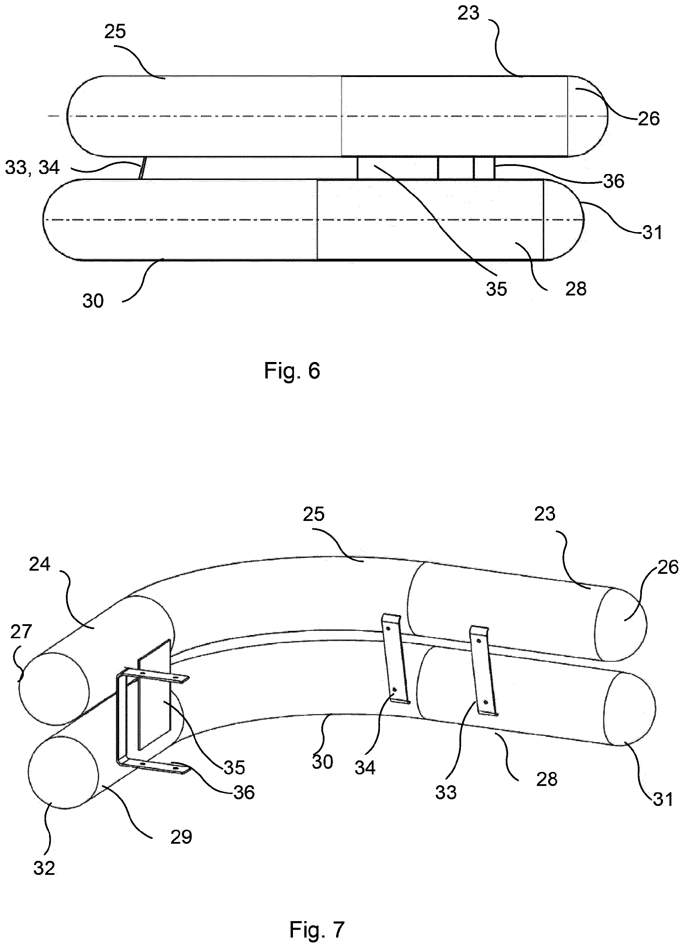

The shielding electrode 20, which is made of an electrically conducting material, for instance a metal such as aluminum. will in the following be described in some more detail, with reference also being made to fig. 4 - 7, where fig. 4 illustrates a view from above of the electrode, fig. 5 illustrates a view of electrode seen from a side that is to be connected to the piece of equipment, fig. 6 shows a side view of the electrode and fig. 7 shows an isometric view of the electrode.

As can be seen in fig. 4 - 7, the shielding electrode comprises two tubular shielding elements, which may be L-shaped as well as hollow. Each tubular shielding element 21 and 22 comprises a first and second straight tubular section, where a first straight section of a tubular element is joined to the second section of the element by a bent central tubular section. Each straight section of each tubular element is further joined with a hemispherical dome opposite of the central section. The first straight section 23 of the first tubular shielding element 21 thus has a first end where it is joined with a first end of the central section 25. It also has a second end where it is joined with a first hemispherical dome section 26. In a similar manner the second straight section 24 of the first tubular shielding element 21 has a first end where it is joined with a second end of the central section 25. The second straight section 24 also has a second end where it is joined with a second hemispherical dome section 27. Analogously, the first straight section 28 of the second tubular shielding element 22 has a first end where it is joined with a first end of the central section 30. It likewise has a second end where it is joined with a first hemispherical dome section 31. In a similar manner the second straight section 29 of the second tubular shielding element 22 has a first end where it is joined with a second end of the central section 30. The second straight section 29 also has a second end where it is joined with a second hemispherical dome section 32. Finally, the two tubular shielding elements are electrically interconnected with each other. They may also be connected to the same point of the valve stack and may or may not be electrically connected to a potential of a part of a valve of the valve stack.

The straight sections also stretch out from the central bent section at an angle of at least sixty degrees to each other in a horizontal plane and with advantage at an angle of 90 degrees to each other. The angle may also depend on the angle between the first and second sides of piece of equipment. As it can be understood also from fig. 2 and 3, the central section of the first shielding electrode is centered around the first edge 16 with one straight section covering the first side stretching out along this first side perpendicular to the direction of the first edge 16 and with the other straight section covering the second side stretching out along this second side with an orientation that is aligned with the orientation of the cooling fluid tubes on the second side. The central section of the second electrode centered around the second edge has one straight section stretching out along this third side perpendicular to the direction of this second edge and has the other straight section covering the second side stretching out along this second side with an orientation that is aligned with the orientation of the cooling fluid tubes on the second side. Although it is not completely evident from fig. 4 - 6, the first and second straight sections of a shielding element may be angled to each other in a second way. One straight section may be essentially horizontally oriented, i.e. stretch out from the first edge in a horizontal direction. The other straight section that is to cover the cooling tubes instead stretches out from the first edge with an angle to the horizontal plane. There may therefore be a difference in an angle of inclination between the straight sections in relation to the horizontal plane, where one straight section may lack such an angle of inclination and the other straight section has an angle of inclination.

As can be seen in fig. 4-7, the electrode 20 also comprises supports 33, 34, 35 and 36 for mechanical fixation in the shielding structure. One or more of these supports may also be used for the above described electrical interconnection of the two tubular elements.

The electrode 20 fulfils three basic requirements:
- The geometrical design does not permit the inception of corona discharges on its surface for the SIWL requirements.
- It is adapted to the mechanical constraints imposed by the converter valve construction, allowing an easy mounting.
- It is possible to manufacture at a good cost and quality.

It is thus clear a shielding electrode and therefore also shielding structure is obtained that is compact in size while at the same time fulfilling the SIWL requirements.

It should here be realized that the shielding structure may be built in a number of ways. The tubes being covered by the electrode 20 need not be metal tubes, but may be plastic. It is in fact possible that the other tubes on the short sides that are not covered by the shielding electrode are also plastic tubes, which may be covered by similar or other types of shielding electrodes. One type of such other shielding electrode may be in the form of a screen at a distance from the valve stack. It may also have a shape that stretches around any edges or corners of the physical stack shape.

It should also be realized that it is possible that more than two tubular shielding elements are used in the shielding electrode.

Exposed surfaces of the equipment are thus protected by a shielding structure against corona discharges and electrical breakdown from the valve to neighboring objects such as the enclosure, like a wall or to the floor.

The neighboring object was above exemplified by an enclosure in the form of a valve hall. It should be realized that the neighboring object is in no way limited to such an object. In fact the neighboring object does not have to be an enclosure but can be separate objects close to a part of the HV equipment.

From the foregoing discussion it is evident that the present invention can be varied in a multitude of ways.

It shall consequently be realized that the present invention is only to be limited by the following claims.

## Claims

1. A shielding electrode (20) for a piece of high voltage equipment having a first and second end (4, 3), a first and second side and an edge (16) separating the first side from the second side, where the edge (16) stretches along a direction between the first end (4) and the second end (3), said shielding electrode (20) comprising two tubular shielding elements (21, 22), each comprising a first and second straight tubular section (23, 24, 28, 29), joined to each other by a bent central tubular section (25, 30) and stretching out from the central bent section (25, 30) at an angle of at least sixty degrees to each other, where the central section (25, 30) is configured to be centered around the edge (16) with the first and second straight sections (23, 24, 28, 29) stretching along said two sides and the two shielding elements (21, 22) are configured to be placed after each other along said direction,.
wherein each straight section (23, 24, 28, 29) of each tubular element (21, 22) is further joined with a hemispherical dome (26, 27, 31, 32) opposite of the joining to the central section (25, 30).

2. The shielding electrode according to claim 1, wherein the angle is at least ninety degrees

3. A shielding structure for a piece of high voltage equipment, said piece of high voltage equipment having a first and second end (3, 4), a first and second side and an edge (16) separating the first side from the second side, where the edge (16) stretches along a direction between the first end (4) and second end (3) and the piece of equipment has an electric potential that varies along the edge (16), said shielding structure comprising a shielding electrode (20) according to any previous claim.

4. The shielding structure according to claim 3, where the electric potential at the first end (4) is higher than the electric potential at the second end (3) and the shielding electrode (20) is closer to the first than the second end.

5. The shielding structure according to claim 4, wherein the electric potential at the first end (4) is the highest of the equipment.

6. The shielding structure according to claim 5, wherein the absolute value of the electric potential is higher than 400 kV.

7. The shielding structure according to any of claims 3-6, comprising a further shielding element (17) for covering the first end (4) of the piece of equipment and the shielding electrode (20) is placed adjacent the further shielding element (17).

8. The shielding structure according to any claims 3 - 7, wherein there are cooling fluid tubes (14) on the second side of the piece of equipment (1) and the tubular shielding elements (21, 22) cover at least some of said cooling fluid tubes in the vicinity of the edge.

9. The shielding structure according to claim 8, wherein at least some of the cooling fluid tubes (14) are of an electrically conducting material for shielding the second side of the piece of equipment.

10. The shielding structure according to any of claims 3 - 9, further comprising shielding plates (15) for placement on the first side of the piece of equipment.

11. A high voltage arrangement comprising a piece of high voltage equipment having a first and second end (4, 3), a first and second side and an edge (16) separating the first side from the second side, where the edge (16) stretches along a direction between the first end (4) and the second end (3) and the equipment has a varying electric potential along the edge (16), the high voltage arrangement further comprising a shielding structure according to any of claims 3 - 10.

12. The high voltage arrangement according to claim 11, wherein the piece of high voltage equipment is a converter comprising a number of converter valves (1, 2) stacked along said direction.

13. The high voltage arrangement according to claim 11, wherein the piece of high voltage equipment is a reactor.

14. A converter station comprising a converter for converting between alternating current and direct current, said converter comprising a valve stack (1, 2) having a first and second end (4, 3), a first and second side and an edge (16) separating the first side from the second side, where the edge (16) stretches along a direction between the first end (4) and the second end (3) and the converter has a varying electric potential along the edge, said converter station further comprising a shielding structure according to any of claims 3 - 10.

## Patentansprüche

1. Abschirmelektrode (20) für ein Hochspannungsgerät mit einem ersten und einem zweiten Ende (4, 3), einer ersten und einer zweiten Seite und einer Kante (16), die die erste Seite von der zweiten Seite trennt, wobei sich die Kante (16) entlang einer Richtung zwischen dem ersten Ende (4) und dem zweiten Ende (3) erstreckt, wobei die Abschirmelektrode (20) zwei rohrförmige Abschirmelemente (21, 22) umfasst, die jeweils einen ersten und einen zweiten geraden rohrförmigen Abschnitt (23, 24, 28, 29) umfassen, miteinander durch einen gebogenen zentralen rohrförmigen Abschnitt (25, 30) verbunden sind und sich von dem zentralen gebogenen Abschnitt (25, 30) in einem Winkel von mindestens sechzig Grad zueinander erstrecken, wobei der zentrale Abschnitt (25, 30) so ausgebildet ist, dass er um die Kante (16) zentriert ist, wobei sich der erste und der zweite gerade Abschnitt (23, 24, 28, 29) entlang der beiden Seiten erstrecken und die beiden Abschirmelemente (21, 22) so ausgebildet sind, dass sie entlang der Richtung hintereinander angeordnet sind, wobei jeder gerade Abschnitt (23, 24, 28, 29) jedes rohrförmigen Elements (21, 22) ferner mit einer halbkugelförmigen Kuppel (26, 27, 31, 32) gegenüber der Verbindung mit dem mittleren Abschnitt (25, 30) verbunden ist.

2. Abschirmelektrode nach Anspruch 1, wobei der Winkel mindestens neunzig Grad beträgt.

3. Abschirmstruktur für ein Hochspannungsgerät, wobei das Hochspannungsgerät ein erstes und ein zweites Ende (3, 4), eine erste und eine zweite Seite und eine Kante (16) aufweist, die die erste Seite von der zweiten Seite trennt, wobei sich die Kante (16) entlang einer Richtung zwischen dem ersten Ende (4) und dem zweiten Ende (3) erstreckt und das Gerät ein elektrisches Potential aufweist, das sich entlang der Kante (16) ändert, wobei die Abschirmstruktur eine Abschirmelektrode (20) nach einem der vorhergehenden Ansprüche umfasst.

4. Abschirmstruktur nach Anspruch 3, wobei das elektrische Potential am ersten Ende (4) höher ist als das elektrische Potential am zweiten Ende (3) und die Abschirmelektrode (20) näher am ersten als am zweiten Ende liegt.

5. Abschirmstruktur nach Anspruch 4, wobei das elektrische Potential am ersten Ende (4) das höchste des Gerätes ist.

6. Abschirmstruktur nach Anspruch 5, wobei der Absolutwert des elektrischen Potentials höher als 400 kV ist.

7. Abschirmstruktur nach einem der Ansprüche 3-6, die ein weiteres Abschirmelement (17) zur Abdeckung des ersten Endes (4) des Gerätes umfasst, wobei die Abschirmelektrode (20) neben dem weiteren Abschirmelement (17) angeordnet ist.

8. Abschirmstruktur nach einem der Ansprüche 3-7, wobei auf der zweiten Seite des Gerätes (1) Kühlflüssigkeitsrohre (14) vorhanden sind und die rohrförmigen Abschirmelemente (21, 22) zumindest einige der Kühlflüssigkeitsrohre in der Nähe der Kante abdecken.

9. Abschirmstruktur nach Anspruch 8, wobei zumindest einige der Kühlflüssigkeitsrohre (14) aus einem elektrisch leitenden Material zur Abschirmung der zweiten Seite des Gerätes bestehen.

10. Abschirmstruktur nach einem der Ansprüche 3-9, die ferner Abschirmplatten (15) zur Anordnung auf der ersten Seite des Gerätes umfasst.

11. Hochspannungsanordnung, umfassend ein Hochspannungsgerät mit einem ersten und einem zweiten Ende (4, 3), einer ersten und einer zweiten Seite und einer Kante (16), die die erste Seite von der zweiten Seite trennt, wobei sich die Kante (16) entlang einer Richtung zwischen dem ersten Ende (4) und dem zweiten Ende (3) erstreckt und das Gerät ein variierendes elektrisches Potential entlang der Kante (16) aufweist, wobei die Hochspannungsanordnung ferner eine Abschirmstruktur nach einem der Ansprüche 3-10 umfasst.

12. Hochspannungsanordnung nach Anspruch 11, wobei das Hochspannungsgerät ein Umrichter ist, der eine Anzahl von Umrichterventilen (1, 2) umfasst, die entlang der genannten Richtung gestapelt sind.

13. Hochspannungsanordnung nach Anspruch 11, wobei das Hochspannungsgerät eine Drossel ist.

14. Umrichterstation mit einem Umrichter zur Umwandlung zwischen Wechselstrom und Gleichstrom, wobei der Umrichter einen Ventilstapel (1, 2) mit einem ersten und einem zweiten Ende (4, 3), einer ersten und einer zweiten Seite und einer Kante (16), die die erste Seite von der zweiten Seite trennt, umfasst, wobei sich die Kante (16) entlang einer Richtung zwischen dem ersten Ende (4) und dem zweiten Ende (3) erstreckt und der Umrichter ein variierendes elektrisches Potential entlang der Kante aufweist, wobei die Umrichterstation ferner eine Abschirmstruktur nach einem der Ansprüche 3-10 umfasst.

## Revendications

1. Électrode de blindage (20) pour une pièce d'équipement à haute tension ayant une première et une deuxième extrémité (4, 3), un premier et un deuxième côté et un bord (16) séparant le premier côté du deuxième côté, le bord (16) s'étendant le long d'une direction entre la première extrémité (4) et la deuxième extrémité (3), ladite électrode de blindage (20) comprenant deux éléments de blindage tubulaires (21, 22), chacun comprenant des première et deuxième sections tubulaires droites (23, 24, 28, 29), reliées l'une à l'autre par une section tubulaire centrale coudée (25, 30) et s'étendant à partir de la section centrale coudée (25, 30) à un angle d'au moins soixante degrés l'une par rapport à l'autre, où la section centrale (25, 30) est configurée pour être centrée autour du bord (16) avec les première et deuxième sections droites (23, 24, 28, 29) s'étendant le long desdits deux côtés et les deux éléments de blindage (21, 22) sont configurés pour être placés l'un après l'autre le long de ladite direction,
dans laquelle chaque section droite (23, 24, 28, 29) de chaque élément tubulaire (21, 22) est en outre reliée à un dôme hémisphérique (26, 27, 31, 32) à l'opposé de la jonction avec la section centrale (25, 30).

2. Électrode de blindage selon la revendication 1, dans laquelle l'angle est d'au moins quatre-vingt-dix degrés.

3. Structure de blindage pour une pièce d'équipement haute tension, ladite pièce d'équipement haute tension ayant des première et deuxième extrémités (3, 4), des premier et deuxième côtés et un bord (16) séparant le premier côté du deuxième côté, où le bord (16) s'étend le long d'une direction entre la première extrémité (4) et la deuxième extrémité (3), et la pièce d'équipement ayant un potentiel électrique qui varie le long du bord (16), ladite structure de blindage comprenant une électrode de blindage (20) selon l'une quelconque des revendications précédentes.

4. Structure de blindage selon la revendication 3, dans laquelle le potentiel électrique à la première extrémité (4) est plus élevé que le potentiel électrique à la deuxième extrémité (3) et l'électrode de blindage (20) est plus proche de la première extrémité que de la deuxième extrémité.

5. Structure de blindage selon la revendication 4, dans laquelle le potentiel électrique à la première extrémité (4) est le plus élevé de l'équipement.

6. Structure de blindage selon la revendication 5, dans laquelle la valeur absolue du potentiel électrique est supérieure à 400 kV.

7. Structure de blindage selon l'une quelconque des revendications 3 à 6, comprenant un autre élément de blindage (17) pour couvrir la première extrémité (4) de la pièce d'équipement, et l'électrode de blindage (20) étant placée à côté de l'autre élément de blindage (17).

8. Structure de blindage selon l'une quelconque des revendications 3 à 7, dans laquelle il y a des tubes de fluide de refroidissement (14) sur le deuxième côté de la pièce d'équipement (1) et les éléments de blindage tubulaires (21, 22) couvrent au moins certains desdits tubes de fluide de refroidissement à proximité du bord.

9. Structure de blindage selon la revendication 8, dans laquelle au moins certains des tubes de fluide de refroidissement (14) sont en matériau conducteur d'électricité pour le blindage du deuxième côté de la pièce d'équipement.

10. Structure de blindage selon l'une quelconque des revendications 3 à 9, comprenant en outre des plaques de blindage (15) à placer sur le premier côté de la pièce d'équipement.

11. Agencement haute tension comprenant une pièce d'équipement haute tension ayant une première et une deuxième extrémités (4, 3), un premier et un deuxième côtés et un bord (16) séparant le premier côté du deuxième côté, où le bord (16) s'étend le long d'une direction entre la première extrémité (4) et la deuxième extrémité (3) et l'équipement a un potentiel électrique variable le long du bord (16), l'agencement haute tension comprenant en outre une structure de blindage selon l'une quelconque des revendications 3 à 10.

12. Agencement haute tension selon la revendication 11, dans lequel la pièce d'équipement haute tension est un convertisseur comprenant un certain nombre de vannes de convertisseur (1, 2) empilées le long de ladite direction.

13. Arrangement haute tension selon la revendication 11, dans lequel la pièce d'équipement haute tension est un réacteur.

14. Station de conversion comprenant un convertisseur pour la conversion entre le courant alternatif et le courant continu, ledit convertisseur comprenant un empilement de vannes (1, 2) ayant une première et une deuxième extrémités (4, 3), un premier et un deuxième côtés et un bord (16) séparant le premier côté du deuxième côté, où le bord (16) s'étend le long d'une direction entre la première extrémité (4) et la deuxième extrémité (3) et le convertisseur a un potentiel électrique variable le long du bord, ladite station de conversion comprenant en outre une structure de blindage selon l'une quelconque des revendications 3 à 10.
